Europäisches Patentamt

European Patent Office

Office européen des brevets

(19)

(11) EP 0 800 216 A2

(12) **EUROPEAN PATENT APPLICATION**

(43) Date of publication:
08.10.1997 Bulletin 1997/41

(51) Int Cl.6: **H01L 29/78**, H01L 29/423

(21) Application number: 97301764.3

(22) Date of filing: 17.03.1997

(84) Designated Contracting States:
DE FR GB IE

(30) Priority: 04.04.1996 US 627364

(71) Applicant: International Business Machines
Corporation
Armonk, N.Y. 10504 (US)

(72) Inventors:
• Phan, Nghia Van
Rochester, Minnesota 55902 (US)
• Sheets II, John Edward
Zumbrota, Minnesota 55992 (US)

(74) Representative: Moss, Robert Douglas
IBM United Kingdom Limited
Intellectual Property Department
Hursley Park
Winchester Hampshire SO21 2JN (GB)

(54) **Transistor gate to minimize agglomeration defect sensitivity**

(57)    A field effect transistor is provided which includes a substrate having an active region and an adjacent non-active region. A gate conductor having a first gate conductor cross-sectional area is provided proximate the active region of the substrate. An increased gate conductor cross-sectional area is provided at the intersection of the active region and the non-active region to provide parallel current paths in order to circumvent agglomeration defects formed at the intersection.

FIGURE 4A

EP 0 800 216 A2

## Description

### FIELD OF THE INVENTION

The present invention relates generally to field effect transistor devices, and more particularly to minimizing the adverse effects of agglomeration defects formed on field effect transistor gate conductors.

### BACKGROUND OF THE INVENTION

A number of serious performance issues have been related to a pervasive semiconductor fabrication problem known as agglomerations. Agglomerations have been shown to occur on field effect transistor polysilicon gates at the non-planar step of the recessed oxide region which is referred to as the "transistor edge". These agglomerations have been empirically determined to result in an approximately 1,000 ohm increase in resistance of the gate conductor, which can significant reduce the performance of the circuit in which it resides, particularly in instances where relatively high currents are present. It has been discovered that the density of the agglomeration defects is strongly dependent on the width of the gate conductor traversing the transistor edge, with relatively wide lines (on the order of 1 um) having essentially zero defect density. The density of defect increases significantly under 1 um, and gate conductors having widths under 0.5 um have a very high defect density, which continues to increase with each small decrease in gate conductor line width.

As more advanced semiconductor processes continue to decrease the gate conductor line width, the agglomeration defect problems become more significant. It is therefore desirable to minimize the agglomeration defects without burdening technological advances in the narrowing of gate conductor line width.

U.S. Patent No. 5,416,352 issued to Takada on May 16, 1995, recognizes a defect or interface state in the interface region between a field oxide film 4 and the gate oxide film 5. Takada utilizes a 2-layered electrode layer having a first electrode layer high in resistance than a second electrode layer. The first electrode layer of high resistance in the boundary region acts as a insulating layer which, in combination with a thin insulating film generates a capacitive effect. A lower voltage than the entire voltage is applied to the thin insulating film, and the electric field strength applied to the thin insulating film is considerably weakened in the boundary region. This 2-layered electrode structure is designed to improve the dielectric strength of the device.

A problem with the Takada invention is that it requires the fabrication of an additional electrode layer in the field effect device. Furthermore, the resistances of each of the electrode layers must be appropriately doped in order to obtain the desired result. This solution can further complicate the fabrication of the semiconductor device.

### DISCLOSURE OF THE INVENTION

The present invention relates to an apparatus and method for minimizing the detrimental effects of agglomeration defects in field effect devices.

In accordance with one aspect of the present invention, a field effect transistor, as claimed in Claim 1, is provided. Preferred further features are specified in its dependent claims.

In accordance with a second aspect, the invention provides a method as claimed in Claim 5, with preferred further features as specified in its dependent claims.

The present invention provides an improved gate conductor at the transistor edges to limit the sensitivity to agglomeration defects. Traditional field effect transistor fabrication techniques limit the shape and angles of the gate conductors in the transistor active regions due to potential short channel effects, gate-to-diffusion shorting potential and other spacer oxide related issues. The present invention increases the conductivity at the transistor edges by increasing the gate conductor cross-sectional area at the transistor edges, without requiring modification to the remainder of the gate channel.

### BRIEF DESCRIPTION OF THE DRAWINGS

The invention will now be described, by way of example only, with reference to the accompanying drawings, in which:

Figure 1 illustrates a cross-sectional portion of a typical field effect transistor which can exhibit agglomeration defects;

Figure 2 is an enlarged cross-sectional diagram showing the approximate location of the agglomeration defects;

Figure 3 illustrates a top view of the agglomeration defects on a prior art gate conductor;

Figures 4A - 4G illustrate various embodiments of the improved gate conductor of the present invention;

Figure 5A illustrates the rationale for using the novel gate conductor width expansion techniques as opposed to providing a uniformly wide gate conductor;

Figure 5B shows the transistor length and width measurements for one embodiment of the present invention.

### DETAILED DESCRIPTION OF THE PREFERRED EMBODIMENTS

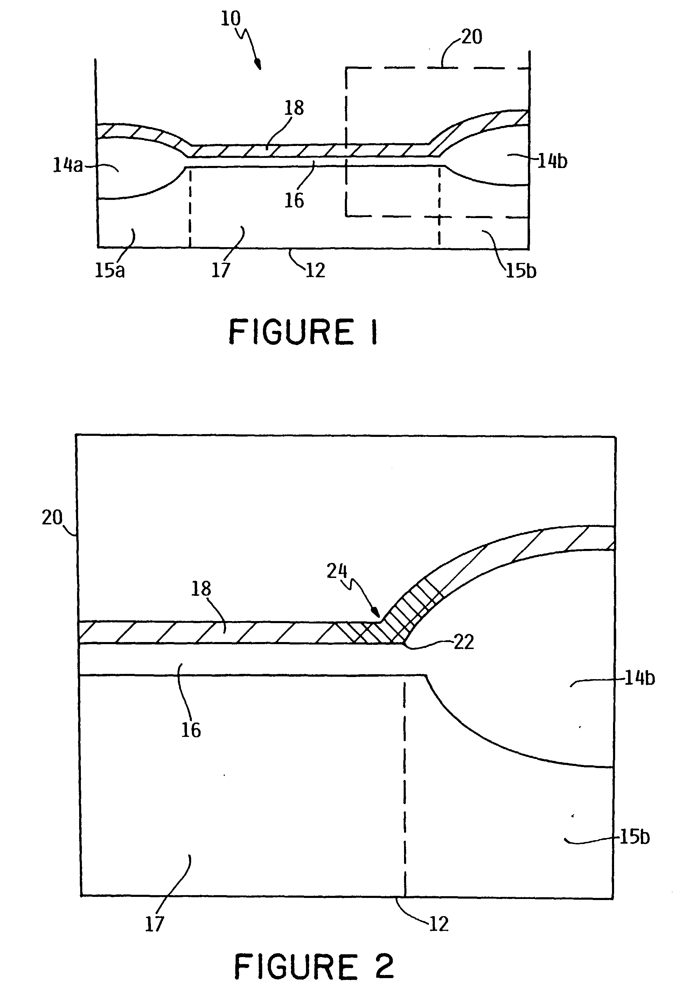

Figure 1 illustrates a portion of a typical field effect transistor (FET) 10 which can exhibit agglomeration defects. The field effect transistor 10 includes semiconductive substrate 12, typically silicon. Field-oxide regions 14a and 14b are formed above the respective non-active portions 15a and 15b of the substrate 12. Field-oxide regions 14a and 14b represent isolation regions used to isolate successive transistors in the wafer fabrication process. These field-oxide regions are required in order to prevent the formation of a conducting path, or pseudo-channel, from forming between the transistors on the wafer. Gate-oxide layer 16 is formed on the active region 17 of substrate 12 adjacent to and integrally coupled to field-oxide regions 14a and 14b. Gate-oxide layer 16 forms the dielectric between substrate 12 and the gate conductor 18. The gate conductor 18 of the preferred embodiment comprises a polysilicon material. Area 20 of Figure 1 shows the area to be considered in analyzing the location of the agglomeration defects.

Figure 2 is an enlarged diagram showing the approximate location of the agglomeration defects. Gate conductor 18 is formed along gate-oxide layer 16, and is continually formed over the non-planar field-oxide region 14b. The gate conductor 18 becomes non-planar at the intersection of field-oxide layer 14b and gate-oxide layer 16, which is shown at location 22. The agglomeration defects tend to occur at this intersection or boundary, as agglomeration defect 24 illustrates. The agglomerations are polysilicon crystalline structure deformations at the non-planar boundary. Agglomerations have been empirically found to occur randomly, but do not form on flat, planar surfaces.

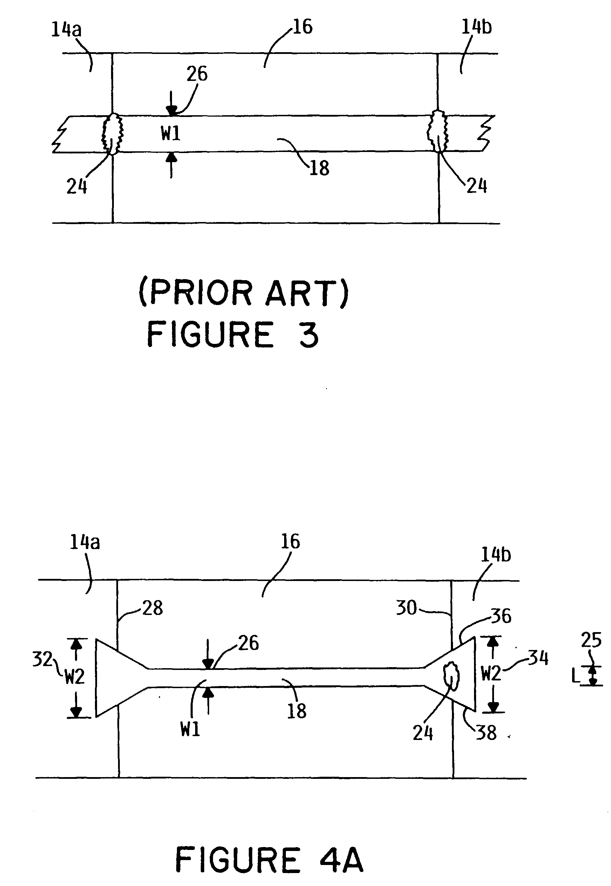

Figure 3 illustrates a top view of agglomeration defects on a prior art gate conductor 18. Gate conductor 18 has a uniform width across gate-oxide layer 16 from field-oxide layer 14a to field-oxide layer 14b. The agglomeration defects 24 can be seen on the gate conductor 18 at the intersections of the field-oxide layers 14a and 14b and the gate-oxide layer 16. Agglomerations tend to be on the order of approximately 0.25 um in width. Where the gate conductor 18 has a width approximately equal to the width of the agglomeration, the resistance of the gate conductor 18 can increase by as much as 1,000 ohms or more. This can have a significant effect on the performance of the field effect transistor, particularly where relatively high currents are present in the gate material. As seen in Figure 3, the agglomerations 24 are approximately equal to the width W1 26 of the gate conductor 18, which thereby increases its resistance.

Figures 4A - 4G illustrate various embodiments of the improved gate conductor of the present invention. Figure 4A illustrates a first embodiment of the invention that alleviates the adverse effects of the agglomeration defects, yet allows the gate conductor on the active region 17 to remain at a very fine width. A narrow gate conductor 18 allows for a shorter transistor length L 25. As can be seen in Figure 4A, gate conductor 18 has a width of W1 26 until it approaches boundaries 28 and 30 created by the respective adjacent portions of the of gate-oxide layer 16 and the field-oxide layers 14a and 14b. The width of gate conductor 18 then increases until it reaches a second width, shown as W2 32 and W2 34. It should be noted that the second width W2 32 proximate boundary 28 does not have to be of equal width to the second width W2 34 proximate boundary 30.

Agglomerations pose a problem where the defect size is as large as, or larger than, the width of the gate conductor. In the preferred embodiment, a polysilicon gate material is used as the gate conductor 18. The density of the agglomeration defects are strongly dependent on the width of the polysilicon gate conductor traversing the transistor edge. Furthermore, agglomeration defects have been found to be on the order of .25um wide on polysilicon gate conductors.

Referring now to the gate conductor 18 proximate boundary 30, it can be seen that gate conductor 18 increases in width in a V-shape, or triangular shape, having sides 36 and 38. Sides 36 and 38 are angled from the longitudinal axis of gate conductor 18 on gate-oxide layer 16. This allows the gate conductor 18 to be wider than the agglomeration defect 24 at boundary 30. This provides parallel current paths around the agglomeration defect 24, thereby minimizing the resistive characteristics of the defect.

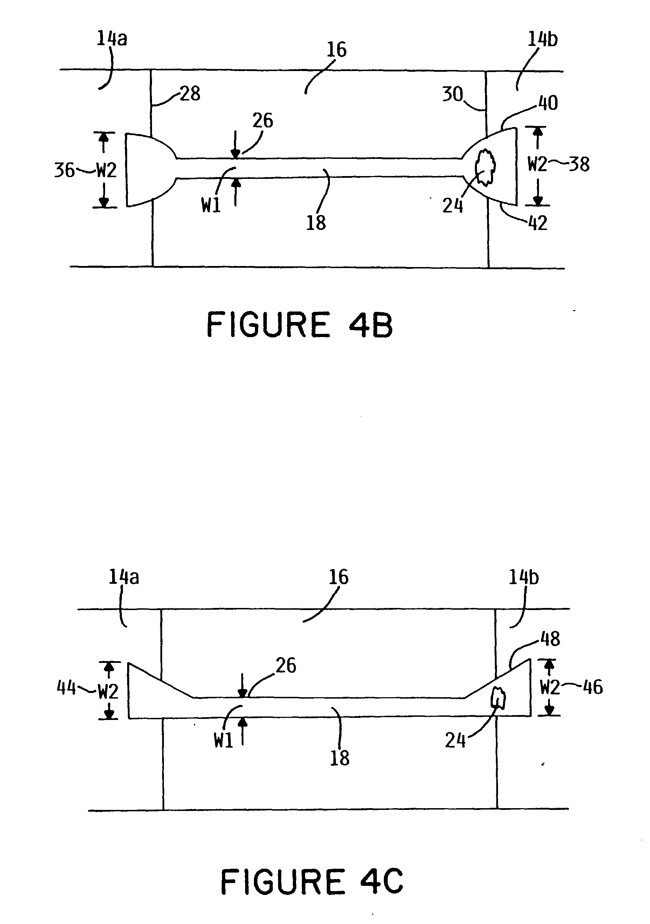

The invention therefore provides an increased cross-sectional area for current to flow around an agglomeration defect, without requiring the gate conductor 18 over the active region to be widened. The increased cross-sectional area in the preferred embodiment results from widening the gate conductor 18 proximate the boundaries 28 and 30. Figure 4A is but one embodiment of the present invention, and the invention is therefore not limited as such. Figures 4B through 4G illustrate other embodiments, however the invention is not limited to the exact shapes and sizes depicted.

Figure 4B illustrates a gate conductor 18 that increases hyperbolically proximate boundaries 28 and 30. Gate conductor 18 has a width of W1 26 until it approaches boundaries 28 and 30, where its width is increased until it obtains a second width, shown as W2 36 and W2 38. Gate conductor 18 increases in width hyperbolically having sides 40 and 42.

Figure 4C depicts another embodiment of the invention, wherein gate conductor 18 has a width of W1 26 until it approaches boundaries 28 and 30, where its width is increased to width W2 44 and W2 46 respectively. The increased cross-sectional area is obtained by angling the gate conductor 18 as shown by side 48.

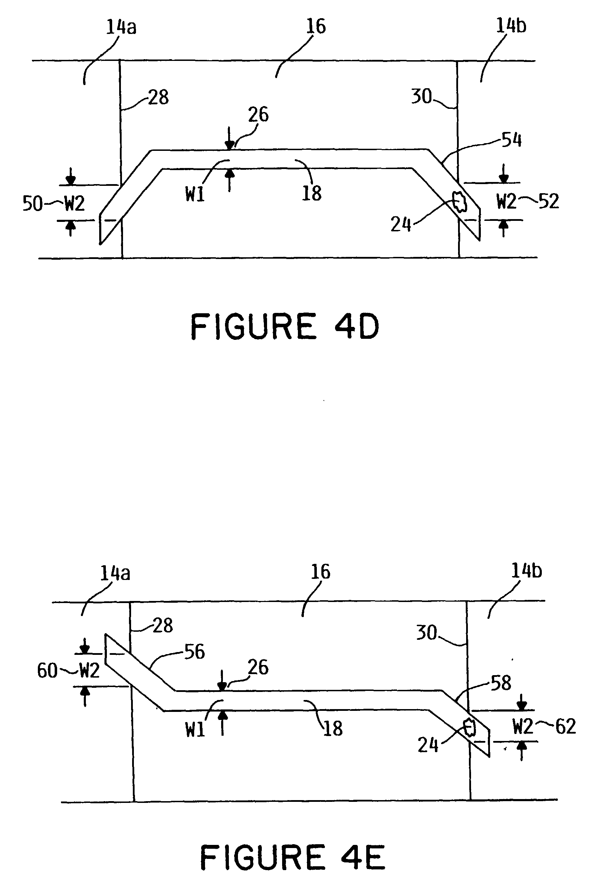

Figures 4D and 4E illustrate embodiments wherein the gate conductor itself is acutely angled from its longitudinal axis to obtain second gate conductor widths. The gate conductor 18 of Figure 4D is angled proximate boundaries 28 and 30 to respectively obtain second widths W2 50 and W2 52. These increased widths W2 are the result of changing the direction of the gate conductor so that it is more parallel to the boundaries 28 and 30. For example, the longitudinal axis of gate conductor 18 over the active region of field effect transistor 10 is approximately perpendicular to boundary 30, but leg 54 is at an acute angle to boundary 30, which is more parallel to boundary 30, thereby covering a greater portion of boundary 30 with the gate conductor 18. The angled gate conductor leg 54 itself can also be widened to more directly increase the width W2 52. Figure 4E exhibits an embodiment similar to that of Figure 4D, except that the angled legs 56 and 58 are symmetric about the longitudinal axis of gate conductor 18. The increased widths W2 60 and W2 62 occur in the same manner as W2 50 and W2 52 of Figure 4D were described.

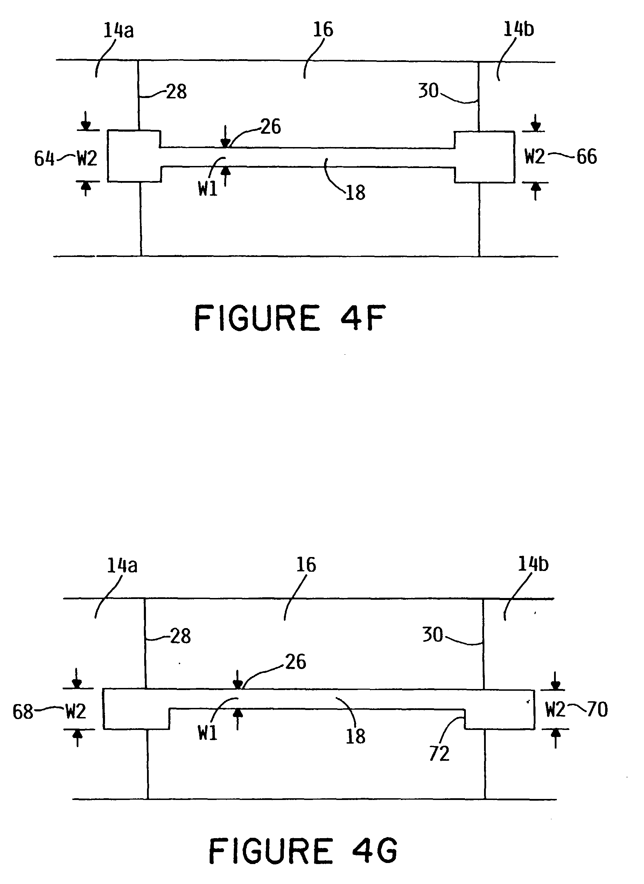

Figures 4F and 4G illustrate embodiments wherein the gate conductor is widened perpendicularly from its longitudinal axis. Figure 4F shows WI 26 increasing perpendicularly to obtain second widths W2 64 and W2 66 proximate boundaries 28 and 30 respectively. Similarly, second widths W2 68 and W2 70 of Figure 4G increase perpendicularly to the longitudinal axis of the gate conductor 18, however this increase is unidirectional, as side 72 depicts.

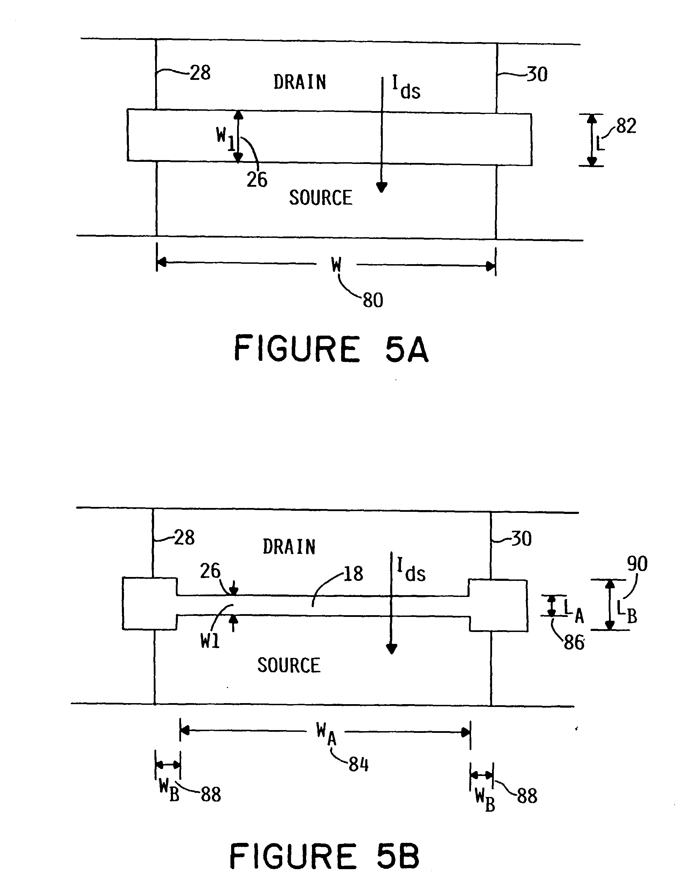

Figure 5A illustrates the rationale for using the novel gate conductor width expansion techniques as opposed to providing a uniformly wide gate conductor. Transistor-on currents are, to the first order, directly proportional to the *transistor* width W 80, and inversely proportional to *transistor* length L 82. Therefore, the drain-to-source current $I_{ds}$ can be represented as shown in Equation 1 below:

$$I_{ds} \propto W/L \; ; \qquad \text{[Equation 1]}$$

where $I_{ds}$ is the drain-to-source current, W is the transistor width, and L is the transistor length. The *transistor* length is therefore shortened by decreasing the gate conductor width W1 26, which thereby decreases the transistor length L 82.

Figure 5B shows the transistor length and width measurements for one embodiment of the present invention. Figure 5B essentially has three parallel transistor currents which can be shown by Equation 2 below:

$$I_{ds} \propto [W_A/L_A + 2 (W_B/L_B)] \; ;$$

[Equation 2]

where $I_{ds}$ is the drain-to-source current, $W_A$ 84 and $L_A$ 86 are the transistor dimensions over a first portion of the transistor, and $W_B$ 88 and $L_B$ 90 are the transistor dimensions near the boundaries 28 and 30. Because $L_B$ 90 is larger than $L_A$ 86, the total drain-to-source current is reduced by the ratio of $L_B/L_A$ over distance $2(W_B)$. The transistor length, which corresponds to the conductor width, affects the performance of the transistor since a uniform increase in the width $W_1$ 26 of gate conductor 18 over the entire transistor width reduces the drain-to-source current. As can be seen in Figure 5B, the width of gate conductor 18 can remain narrow over a substantial portion of the transistor to minimize this drain-to-source current reduction, and the width increases only at the boundaries 28 and 30 in order to alleviate the agglomeration defect problem.

## Claims

1. A field effect transistor for minimizing the adverse effects of agglomeration defects, the field effect transistor comprising:

   a substrate having an active region adjacent to a non-active region; and

   a gate conductor having a first gate conductor cross-sectional area, and further having an increased second gate conductor cross-sectional area at the intersection of the substrate's active region and non-active region.

2. The field effect transistor as in Claim 1, wherein the second gate conductor cross-sectional area is larger than the agglomeration defect.

3. A field effect transistor as in Claim 1, further comprising:

   a recessed oxide region formed on the non-active region of the substrate;

   said oxide layer formed on the active region of the substrate, the gate oxide layer being adjacent to the recessed oxide region; and

   a gate conductor having a first channel width continuously formed on the recessed oxide region and the gate oxide layer, the gate conductor having an increased second conductor width encompassing an intersection of the recessed oxide region and the gate oxide layer.

4. The field effect transistor as in Claim 3, wherein the increased second conductor width is greater than a width of the agglomeration defect, and whereby the increased second conductor width of the gate channel provides parallel current paths to circumvent the agglomeration defect.

5. A method for minimizing the effects of agglomeration defects occurring on the gate layer of a field effect device, the field effect device including a semiconductive substrate having an active region and an adjacent non-active region, the method comprising the steps of:

forming a continuous gate conductor on the active region and the non-active region; and

increasing the surface area of the gate conductor at a location encompassing an intersection of the active region and the non-active region.

6.  The method of Claim 5, wherein the step of increasing the surface area of the gate conductor comprises the step of increasing the width of the gate conductor.

7.  The method of Claim 6, wherein the step of increasing the width of the gate conductor comprises the step of increasing the width of the gate conductor beyond a defect width of the agglomeration defect.

8.  The method of Claim 5, wherein the step of increasing the surface area of the gate conductor comprises the step of increasing the surface area of the gate conductor in a V-shape to create an enlarged gate conductor at the intersection of the active region and the non-active region.

9.  The method of Claim 5, wherein the step of increasing the surface area of the gate conductor comprises the step of increasing the surface area of the gate conductor parabolically to create an enlarged gate conductor at the intersection of the active region and the non-active region.

10. The method of Claim 5, wherein the step of increasing the surface area of the gate conductor comprises the step of increasing the surface area of the gate conductor perpendicular to, and approximately centered about, a longitudinal axis of the gate conductor to create an enlarged gate conductor at the intersection of the active region and the non-active region.

# FIGURE I

# FIGURE 2

(PRIOR ART)
FIGURE 3

FIGURE 4A

7

## FIGURE 4B

## FIGURE 4C

FIGURE 4D

FIGURE 4E

14a      16      14b

28      30

26

64—W2      W2—66

W1      18

# FIGURE 4F

14a      16      14b

28      30

26

68—W2      W2~70

W1      18

72

# FIGURE 4G

FIGURE 5A

FIGURE 5B